# EUROPEAN PATENT SPECIFICATION

(11) **EP 3 855 191 B1**
(45) Date of publication and mention of the grant of the patent: **19.07.2023**
(21) Application number: 21150922.9
(22) Date of filing: 11.01.2021
(51) Int. Cl.: G01R 22/06, G01R 1/20, H05K 3/32, H05K 3/34, H05K 1/02

(54) **ELECTRICITY METER WITH SHUNT RESISTOR**
ELEKTRIZITÄTSZÄHLER MIT SHUNT-WIDERSTAND
COMPTEUR D'ÉLECTRICITÉ AVEC RÉSISTANCE DE MESURE

(30) Priority: 14.01.2020 DK PA202070028
(43) Date of publication of application: 28.07.2021
(73) Proprietor: Kamstrup A/S, 8660 Skanderborg (DK)
(72) Inventor: Hansen, Jan Tejlgaard, DK-8660 Skanderborg (DK)
(74) Representative: Plougmann Vingtoft a/s

(56) References cited:
- EP-A1- 0 772 050
- EP-A2- 1 229 558
- US-A1- 2008 194 152
- US-A1- 2013 043 111
- US-A1- 2013 307 521

## Description

### FIELD OF THE INVENTION

The present invention relates to the field of electronic electricity meters, especially the field of electronic electricity meters using shunt resistors for current measurements.

### BACKGROUND OF THE INVENTION

Electronic electricity meters are produced in high volume in highly automized production lines. Construction of electricity meters which are suitable for automized production while at the same time being robust and reliant is important.

One type of electronic electricity meters use shunt resistors for measuring the current running from a distribution network into a consumption site. The electricity meters include terminals for connection of the distribution network and the consumption site to the electricity meter. The shunt resistor is arranged between the terminals and the current running from one terminal to the other pass through the resistor. The current is measured by measuring the voltage over the shunt resistor. The shunt resistor is often connected to a measurement circuit arranged on a printed circuit board (PCB).

When a high current run through the resistor the resistor may heat up changing the physical dimensions of the resistor. The shunt resistor may also be connected to or be a part of a breaker circuit which creates vibrations when the breaker connects or disconnects. Such changes of dimensions and vibrations in the shunt resistor may create stresses in the circuit to which the shunt resistor is connected. If the shunt resistor is directly connected to the PCB the stresses and vibrations may damage the PCB, the connection between the shunt resistor and the PCB or components mounted on the PCB. To avoid this a flexible element, such as a wire, is often arranged between the shunt resistor and the PCB. The flexible element is attached to the shunt resistor and then during assembly connected to the PCB by soldering.

Such flexible elements has the disadvantage that they are difficult to handle during production processes especially during automized production processes flexible elements risk being damaged or bent or end up pointing in undesired directions which makes automated assembly processes difficult.

Controlling the position of the flexible element and protecting it against damages is often done by creating subassemblies including fixating elements which increase the number of components. Further, the sub-assemblies may need to be assembled in a manual process. Such sub-assemblies and fixating elements are undesired.

Further reducing the number of processes or repetition of processes is desired to reduce production costs. In example it may be desired that only one soldering process is performed the PCB. In this soldering process all components are soldered to the PCB e.g. in a reflow or wave soldering process.

US 2013/307521 A1 discloses a utility meter with a first conductive member and a circuit board coupled to the first conductive member at a first joint which is disposed along a first elongated strip portion of the circuit board. The first elongated strip portion is configured to flex relative to a main portion of the circuit board in response to thermal expansion or thermal contraction of the first conductive member or a component coupled to the first conductive member.

Hence, an improved connection between a shunt resistor and a PCB would be advantageous, and in particular a connection which is more efficient during assembly and reliable during life time of the electricity meter would be advantageous.

### OBJECT OF THE INVENTION

It is an object of the present invention to provide an electronic electricity meter which is optimized for automized production. Especially it is an object of the invention to provide an electronic electricity meter with robust, reliable and easy to produce connections between a printed circuit board (PCB) and a shunt resistor.

In particular, it may be seen as a further object of the present invention to provide an electricity meter that solves the above mentioned problems of the prior art or provides an alternative to the prior art.

### SUMMARY OF THE INVENTION

Thus, the above described object and several other objects are intended to be obtained in a first aspect of the invention by providing an electricity meter comprising: a controller unit for calculating an amount of consumed energy; at least two terminals for connecting the electricity meter to power lines; a measurement circuit connected to the controller unit and configured for generating a signal indicative of the amount of consumed energy, the measurement circuit comprising: a printed circuit board with at least two resilient connection components mounted on the circuit board; a shunt resistor electrically connected to the terminals and arranged for measuring a current running between two terminals, the shunt resistor comprising at least two shunt contact pins for connecting the shunt resistor to the printed circuit board; Wherein the shunt contact pins are connected to the printed circuit board during assembly of the electricity meter via the pre-mounted resilient connection component on the printed circuit board, by welding the resilient connection component to the shunt contact pins, such that the shunt contact pin can move relative to the printed circuit board.

Resilient connection components mounted in the Printed Circuit Board (PCB) has the advantage that the resilient connection components are fixated relative to the PCB whereby they are at least partly protected by the PCB to avoid bending or deforming during production processes. The resilient connection component when mounted on the PCB is mechanical supported by the stiffness of the PCB whereby it does not easily bend or become damage during handling in the production process. The resilient connection component can be soldered to the PCB during the same soldering process in which other components mounted on the PCB are soldered which is advantageous in that the number of soldering processes is reduced. The shunt resistor is then connected to the resilient connection component at a later time during the production process. In this way the resilient connection component is pre-mounted on the PCB before assembling the electricity meter.

As the shunt resistor is able to conduct a large current running through the terminals of the meter the dimensions and weight of the resistor is large compared to the connections of the PCB and the resilient connection component. For that reason it is advantageous that handling of the shunt resistor is separated from handling of the resilient connection component which is more prone to being damaged during the handling of the separate components.

The shunt resistor may be arranged as part of a bus bar connected to the terminals of the meter in a first sub-assembly in a base part of the meter housing. The already soldered PCB with the resilient connection components pre-mounted may be seen as e second sub-assembly which may be assembled with the first sub assembly in that the PCB is mounted in meter casing base on top of the busbar or at least on top of parts of the bus bar. The shunt contact pins and the resilient connection components are then attached to each other in a welding process. This has the advantage that the number of production processes is reduced in that only a single welding process and a single soldering process is required. Further only the second sub-assembly requires one or more soldering processes.

The resilient connection components has the advantage that the shunt contact pins of the shunt resistor may move relative to the PCB whereby stresses and vibrations in the PCB resistor are reduced. The shunt resistors and / or bus bar may extend due to temperature changes e.g. caused by the current running in the shunt resistor and bus bar. The shunt contact pins are not welded directly to the printed circuit board. The shunt contact pins does not have a direct mechanical contact to the printed circuit board. If the shunt contacts are welded directly to the PCB stresses may be created in the PCB. The shunt resistors / bus bar may be mechanically connected to breakers which create vibrations when connecting or disconnecting, such vibrations are also, at least partly, decoupled from the PCB by the resilient connection component.

Welding the shunt contact pins to the resilient connection components has the advantage that the process is easy to handle during the assembly process. To achieve a good performance of the welding process it is advantageous if the shunt contact pins are made from copper. Copper shunt contact pins are especially advantageous in relation to spot welding due to the low electrical resistance.

The shunt contact pins are arranged for electrically connecting the shunt resistor to the printed circuit board. The shunt contact pins are electrically connected to the printed circuit board during assembly of the electricity meter via the pre-mounted resilient connection component on the printed circuit board, by welding the resilient connection component to the shunt contact pins, such that the shunt contact pin can move relative to the printed circuit board. Thus there is no direct mechanical or electrical contact between the shunt contact pins and the printed circuit board there is only an indirect mechanical and electrical connection between the shunt contact pins and the printed circuit board via the resilient connection component.

In an embodiment of the invention the electricity meter as described above is arranged such that the shunt contact pins extends through holes in the printed circuit board and the holes in the printed circuit board are larger than the shunt contact pins such that there is no direct contact between the shunt contact pins and the printed circuit board. The shunt contact pins extending through the holes in the PCB has the advantage that the meter may be assembled in a layered structure where the PCB is arranged on top of the shunt resistors / bus bar where after the shunt contact pins still are accessible. The connection between the shunt contacts and the resilient connection component may be made in a next assembly step. This is especially advantageous if the resilient connection components are mounted on a first side of the printed circuit board, and the shunt contact pins extends through the holes in the printed circuit board from a second side of the printed circuit board to the first side of the printed circuit board to be welded to the resilient connection components mounted on the first side of the printed circuit board. In this way the shunt contact pins are accessible from the first side of the PCB when the PCB is mounted in the casing base on top of the bus bar.

The size of the holes in the PCB must be large enough to compensate for production tolerances of the components, changes in dimensions due to temperature changes, movements due to vibrations and precision of the production equipment. It is especially advantageous if the resilient connection components each are connected to the printed circuit board via a surface mounted device foot print arranged on the printed circuit board and comprising at least two soldering pads. The two pads of the surface mounted device foot print may be positioned on opposite sides of the hole in the printed circuit board. Mounting the resilient connection component on two pads ensure stable attachment to the PCB.

Preferably the resilient connection components have been mounted on the printed circuit board by a pick and place process and reflow soldered. The pick and place process is well known within the electronic industry where it is performed by pick and place robots. It is advantageous to have the resilient connection component mounted in the same production process as any other surface mounted device (SMD) component mounted on the PCB to optimize the production by minimizing the number of production processes.

The electricity meter according to any of the above embodiments may have resilient connection components which are surface mounted devices or through hole mounted devices;

The resilient connection components of the abovementioned embodiments may be made from copper, aluminium or any other suitable metal. The resilient connection components may be made from a metal strip with at least 4 or at least 6 bends. The bends has the advantage of adding further flexibility to the resilient connection component in various directions.

The electricity meter as described above may have a the shunt resistors made from an alloy comprising copper, manganese and nickel. However other types of shunt resistors may be used.

The shunt resistors of any of the abovementioned embodiments may be punched out of a metal sheet comprising two copper strips separated by a strip of an alloy comprising copper, manganese and nickel. Parts of the sheet may be used for making the bus bar, whereby the shunt resistors become a part of a bus bar which is arranged to connect two of the terminals. Further the bus bar may comprise a breaker for connecting and disconnecting two of the terminals.

In an electricity meter comprising a breaker and an actuator for controlling the breaker, the printed circuit board may further comprise inductive or capacitive position detection means for detecting the position of the breaker and spring connectors for connecting terminals of the actuator to the printed circuit board whereby the printed circuit board may move relative to the breaker. The spring connectors and the inductive or capacitive position detection means has the advantage that the PCB is not fixated relative to the actuator or breaker. This has the effect that the PCB may be "floating" i.e. free or at least partly free to move relative to the breaker, the actuator and the shunt resistors whereby a robust meter is achieved.

In another aspect of the invention a method for producing or assembling an electronic electricity meter is provided. The method comprises the following steps: Mounting of terminals, shunt resistors and optional bus bar in the meter casing base; an optional step of mounting a breaker and breaker actuator in the meter casing base; mounting components including the resilient connection components on the PCB; mounting the PCB in the meter casing base on top of the shunt resistor; welding the resilient connection element to the shunt contact pins; mounting the meter casing cover on the meter casing base to close the meter casing.

### BRIEF DESCRIPTION OF THE FIGURES

The electricity meter according to the invention will now be described in more detail with regard to the accompanying figures. The figures show one way of implementing the present invention and is not to be construed as being limiting to other possible embodiments falling within the scope of the attached claim set.
Figure 1 show an exploded view of a 3 phased electricity meter including 3 bus bars comprising shunt resistors;
Figure 2A shows bus bars comprising shunt resistors and breakers arranged in a meter casing base along with a actuator device for controlling the breaker;
Figure 2B shows details on the interaction between the actuator and the bus bar comprising breaker elements;
Figure 2C shows a bus bar with multiple elements and a single terminal clamp, the second terminal clamp is left out for illustrative purposes;
Figure 2D shows the same as figure 2C from another direction;
Figure 2E shows one element of the busbar including details of the shunt resistor and breaker element;
Figure 3A and 3B show examples of resilient connection components;
Figure 4A - 4C show examples of bus bar elements comprising a shunt resistor arranged for being punched out of a metal sheet comprising strips of different metals;
Figure 5A and 5B shoe details of shunt contact pins extending through holes in a printed circuit board to meet resilient connection components mounted on the printed circuit board.

### DETAILED DESCRIPTION OF AN EMBODIMENT

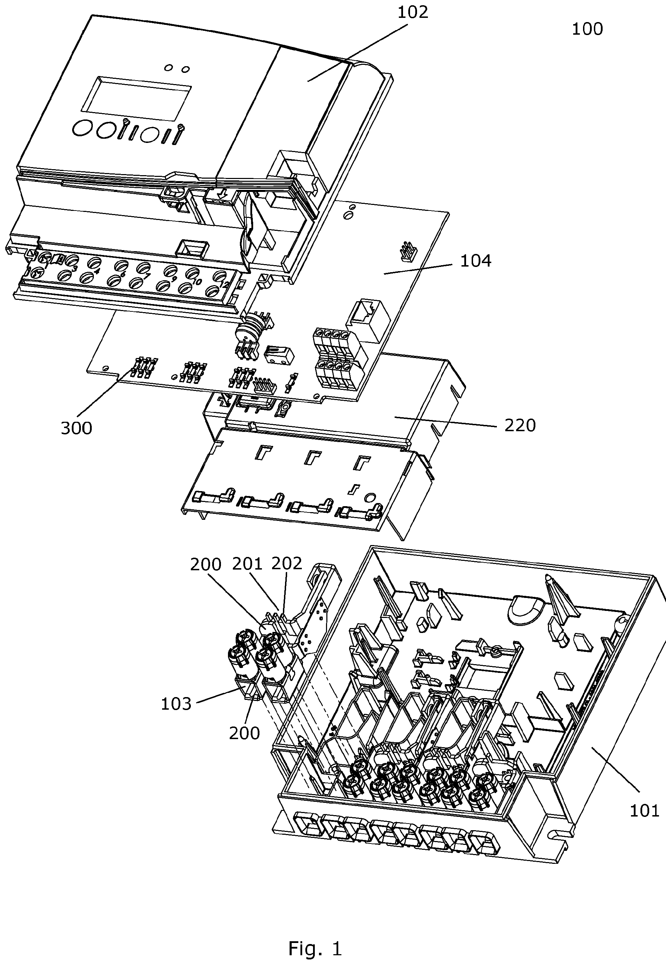

Now referring to figure 1 an embodiment of an electricity meter 100 is described in detail. The electricity meter comprises a meter casing with a meter casing base 101, a meter casing cover 102. The meter casing base and meter casing cover together constitute a meter housing wherein the metrological part of the meter is enclosed. The meter casing base is the basis element upon which the electricity meter is assembled during the production process.

Terminals 103 for connecting power lines to the electricity meter are arranged in the meter casing base. The terminals are electrical connected to a bus bar 200 which also is arranged in the meter casing base to conduct an electrical current between two terminals. A first part of the bus bar is made from copper or another material suitable for conducting high currents. A second part of the bus bar is a shunt resistor 201 made from a material suitable for shunt resistors for current measurement, such as an alloy comprising copper, manganese and nickel. The shunt resister comprises at least two shunt contact pins 202 for connecting the shunt resistor to further circuits. A Printed Circuit Board (PCB) 104 is arranged in the meter casing base above the bus bar. The PCB comprises electronic components and resilient connection components 300 which are connected to the PCB by soldering. The PCB is arranged such that contact between the resilient connection components 300 and the shunt contact pins 202 is created when the PCB 104 is mounted in the meter casing base 101 during production. The shunt contact pins 202 are attached to the resilient connection component 300 by a welding process after the PCB has been mounted in the meter casing base.

Finally additional elements may be arranged in the meter casing base before the meter casing cover is attached to the meter casing base whereby the meter housing is closed.

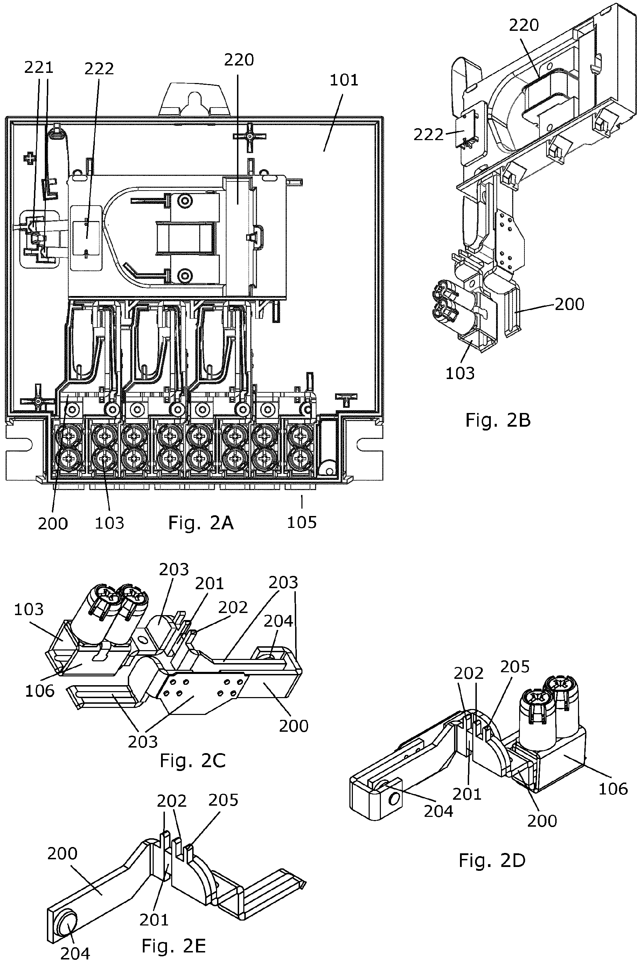

Now referring to figure 2A - 2E the shunt resistor 201, the bus bar 200 and the terminals 103 are described in detail. The terminals are arranged in the meter casing base 101 which has openings 105 for receiving power lines into a cavity of the terminals 103. The terminals are screw terminals arranged for ensuring electrical connection between the power lines and the bus bar 200. The Bus bar has a part extending into the cavity of a terminal clamp 106 for being connected to the power lines. The bus bar extends from a first terminal to a second terminal. The first terminal being intended for connection of power lines from a utility grid and the second terminal being intended for connection of the powerlines of the consumption site. A set of terminals and a bus bar is arranged for each phase and neutral, i.e. a 3 phase meter has 4 sets of terminals and bus bars as illustrated in figure 2A, whereas a 1 phase meter has 2 sets. The bus bar may optionally be fastened in the meter casing base with suitable fastening means such as screws or elements of the meter casing forming a click lock function. In the following only 1 set of terminals and bus bars is described as illustrated in figure 2B - 2E. In figures 2B - 2E one of the terminal clamps are left out for illustrative purposes and figure 2E only illustrates a part of the bus bar. The bus bar comprises several conducting elements 203, a shunt resistor 201 and an optional breaker element 204. The bus bar for neutral may be reduced to only comprising the bus bar and the terminals. The conducting elements of the bus bar are preferably made from copper or another metal suitable for conducting electrical current with a low energy loss. The bus bar may be assembled from several elements which are assembled by known processes such as welding or rivets or simply just pressed together to create an electrical connection. The shunt resistor 201 is made from a shunt material suitable for shunt resistors for current measurement, such as an alloy comprising copper, manganese and nickel also known as Manganin. The shunt resistor comprises at least two shunt contact pins 202 for connecting an electronic circuit to the shunt resistor for measuring the voltage over the shunt resistor generated by the current running through the shunt resistor, whereby a measurement circuit is created. The shunt contact pins 202 may be made from copper or the shunt material or a combination of the shunt material and copper. The bus bar preferably comprises at least one additional bus bar contact pin 205 for measuring the voltage of the bus bar and for supplying the electronic circuits of the electricity meter. Supplying the electronic circuits of the electricity meter from the bus bar contact pin has the advantage that the current running through the pin does not disturb the current measurement made by the shunt resistor and the current used for supplying the electricity meter is not included in the measurement of consumed energy. The bus bar contact pin is made from the same material as the bus bar.

The shunt material is an may be an alloy comprising copper, manganese and nickel. This alloy has a very low temperature coefficient of resistance value and long term stability. The composition is typically 86% copper, 12% manganese, and 2% nickel. Other compositions may be used, the composition is less important for the invention. Manganin is a trademarked name for an alloy comprising copper, manganese and nickel. In the following description when the trade name Manganin is used it shall be understood as an alloy comprising copper, manganese and nickel.

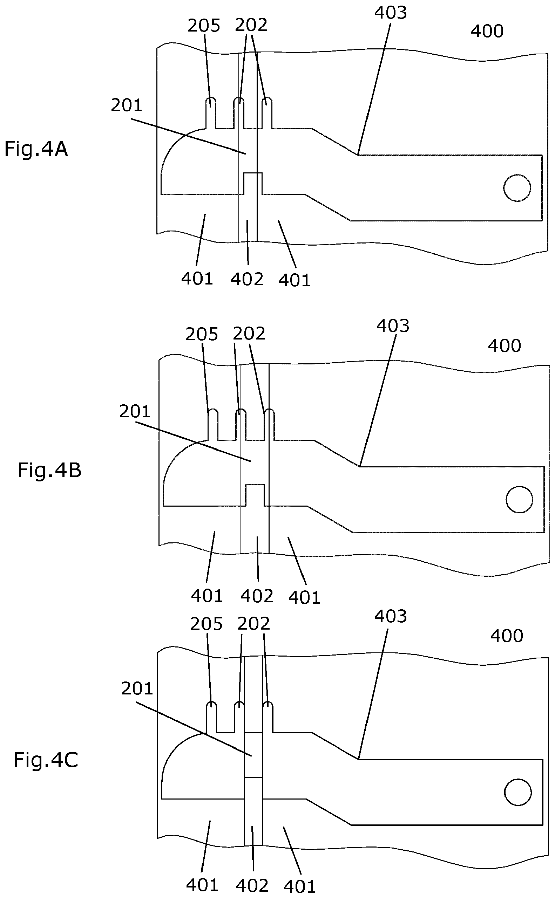

The bus bar or at least part of the bus bar may be punched out of a metal strip 400 comprising two copper strips 401 separated by a Manganin strip 402 as illustrated on figure 4A - 4C. Figures 4A-4C show the sheet with three strips, 401, 402, 401 and the shape 403 of the element punched out of the sheet. The shunt contact pins 202 may be punched out of the copper strips 401 or the Manganin strip 402 or both. Due to production tolerances during punching the contact pins may be made from a combination of Manganin and copper as illustrated in figure 4A or this may be a deliberate choice as shown in figure 4B. Since Manganin is better suited for current measurements than copper normally the shunt contact pins are made from Manganin (not shown on figures) to improve measurement accuracy. However, shunt contact pins made from copper are better suited for welding connecting components to the shunt contact pins due to the low electrical resistance of copper. For that reason the shunt contact pins are made for copper, as shown in figure 4C, to support an optimized production process with a high yield and low error rate. Manganin or Manganin-copper shunt contact pins is a suitable alternative option for the shunt contact pins since welding on such pins is possible despite the above mentioned problems.

The dimensions of the shunt contact pins 202 and bus bar contact pin 205 are selected so that they do not easily bend during the production and assembly process of the electricity meter. The shunt and bus bar contact pins 202, 205 have a cross sectional area of 2 - 4 mm² and a length of 4-6 mm. The dimensions of the shunt contact pins may preferably be arranged such that they do not easily bend during production processes. The length of the shunt and bus bar contact pins 202, 205 depends on the construction of the electricity meter especially the distance between the bus bar and the PCB and the thickness of the PCB. Preferably the shunt and bus bar contact pins 202, 205 has a cross sectional area in the range from 1 mm² to 8 mm² and a length from 2-20 mm, it is to be understood that a longer contact pin must have a greater cross sectional area to avoid bending and being sufficiently stiff.

The bus bar may comprise an optional breaker element 204 for connecting or disconnecting the first and the second terminal. As such the bus part comprises two separate parts which can be electrical connected or disconnected. These two parts including the breaker is understood as one bus bar. If a breaker is included an actuator device 220 for controlling the breaker is included as well. The actuator device 220 including a cover part is illustrated on figure 1 and on figure 2A, 2B the actuator device 220 is illustrated in details. The actuator is arranged in the meter casing base 101 and comprises, electrical connectors 221 for controlling the actuator and means for detecting the position of the breakers or the actuator device. The electrical connectors 221 are springs or resilient elements arranged to connect to a PCB arranged on top of the actuator. The means for detecting the position of the breakers is a metal element 222, such as copper or iron, arranged on a part of the actuator having different positions depending on the state of the breakers. The position of the breakers may then be detected by capacitive or inductive position detection circuits on the PCB arranged over the actuator. The spring connectors and the capacitive or inductive position detection means ensure that the PCB is not mechanical fixated to the actuator or breaker circuit. This has the effect that the PCB may move relative to the actuator and breakers.

The PCB 104 is arranged in the meter casing base 101 over the bus bar 200. The meter casing base may comprise elements arranged for supporting the PCB when mounted in the meter casing base and controlling the position on the PCB in the meter casing base. Electronic components have been mounted on the PCB prior to mounting the PCB in the meter casing base. The components may be surface mounded devices (SMD) or through hole mounted devices or a combination of both. The components have been mounted on the PCB by one or more soldering processes such as reflow or wave soldering. Resilient connection components 300 have been mounted on the PCB during the same production process. The resilient connection components 300 are surface mounted devices (SMD) but may alternatively be through hole mounted components. The resilient connection components are mounted on the PCB in a automized process as is well known in the electronic industry such as a pick and place robot. The printed circuit board 104 (PCB) comprises parts of the measurements circuit for measuring the amount of consumed energy. The PCB may further comprise the controller unit, a display, wired or wireless communication interfaces, buttons for user interaction, power supply circuits, galvanic isolation circuits or any other electronic circuits.

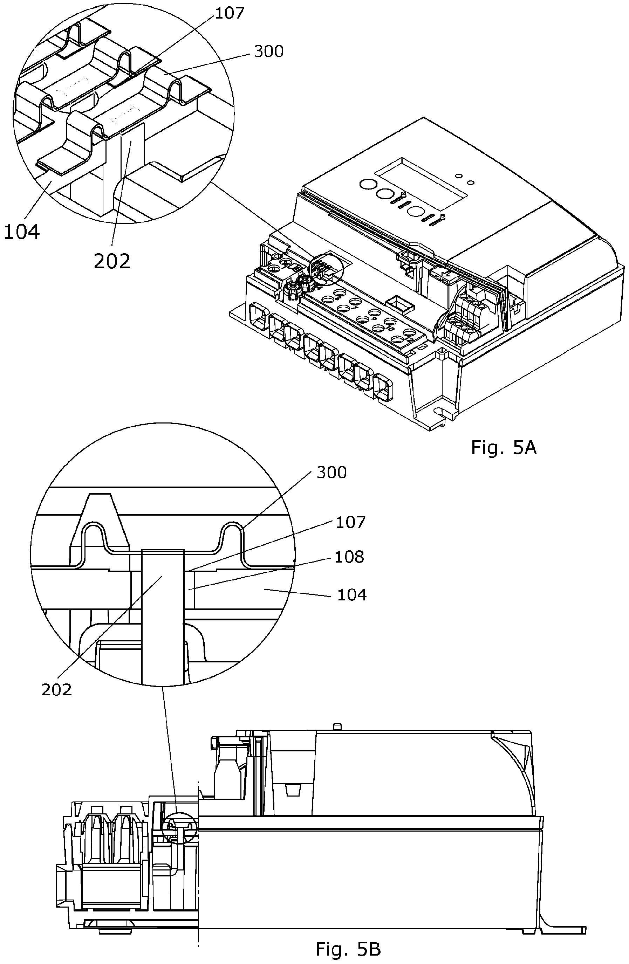

Now referring to figure 5A and 5B. The PCB 104 comprises holes 107 through which the shunt contact pins 202, 205 are arranged to extend when the PCB is mounted in the meter casing base 101 over the bus bar 200. The holes 107 in the PCB board are larger than the shunt contact pins 202, 205 such that there is no direct mechanical contact between the shunt contact pins 202, 205 and the PCB 104. The shunts and the shunt contacts pins can move relative to the PCB without creating mechanical stresses in the PCB. In other words the holes in the PCB are oversized such that there is an open space 108 between the shunt contact pins 202, 205 and the PCB 104 when the shunt contact pins extends through the holes. The open space 108 is in the range from 0,1 - 2 mm. The shunt contact pins 202, 205 are not soldered to the PCB. This has the advantage that the shunt contact pins will not create stresses in the PCB if the bus bar extends due to temperature changes. Further, vibrations will not be transferred directly from the bus bar to the PCB as would be the case if the shunt contact pins were soldered to the PCB.

The resilient connection components 300 are mounted on the PCB 104 so that they extends over the holes 107 in the PCB. When the PCB is mounted in the meter casing base on top of the bus bar the shunt contact pins 202, 205 extends through the holes 107 in the PCB and meets the resilient connection components 300. The resilient connection components 300 are mounted on the top side of the PCB 104, extending over the holes in the PCB. When the PCB is mounted in the meter casing base above the bus bar, the bottom side of the PCB faces the bus bar. The shunt contact pins 202, 205 extends into the holes 107 in the PCB from the bottom side and out of the holes on the top side of the PCB where they meet the resilient connection components 300. After the bus bar 200 and the PCB 104 have been mounted in the meter casing base 101 so that the shunt contact pins 202, 205 meets the resilient connection components 300 through the holes 107 in the PCB 104, the shunt contact pins 202, 205 are attached or connected to the resilient connection components 300 by welding to ensure sufficient and reliable electrical contact between the two elements. The welding process may be any suitable welding process such as spot welding using current or a laser welding. The shunt contact pin 202, 205 is not soldered to the resilient connection component 300. In an alternative solution the shunt contact pins are not attached to the resilient connection components by welding or any other process. In that case the electrical contact between the shunt contact pins and the resilient connection components is created due to mechanical forces between the two elements exerts on each other when they meet each other.

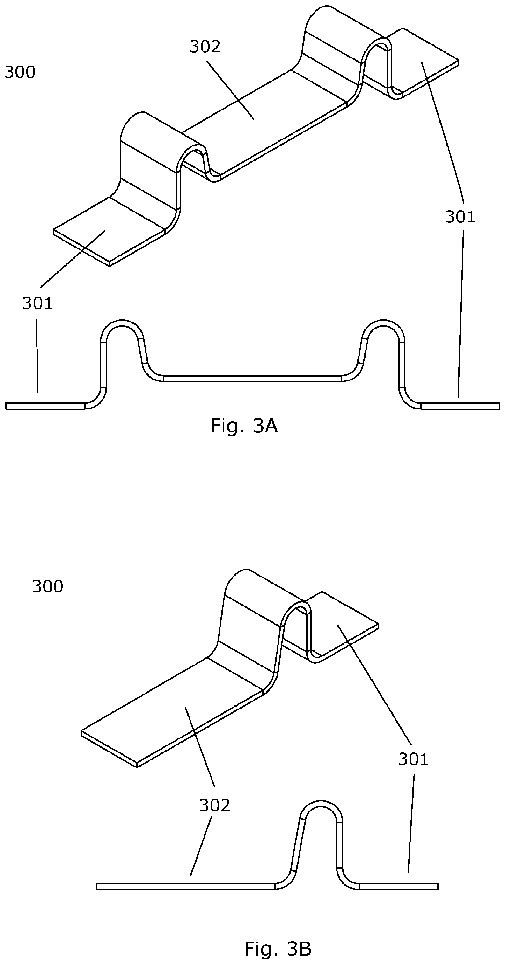

Examples of resilient connection components 300 are shown on figure 3A and 3B. The resilient connection components 300 are made from a metal strip, preferably copper or aluminium or an alloy with similar mechanical and electrical properties. The resilient connection component is a surface mounted device (SMD). It has two feet 301 arranged for soldering to the PCB by reflow soldering. A flat interfacing part 302 for being welded to the shunt contact pins is arranged in between the two feet. The resilient connection component has 6 bends to increase resilience of the component. The 6 bends results in the M shape seen on figure 3A. As an alternative a more simple U shaped for may be created by only four bends. Figure 3B illustrates a resilient connection component with only one foot 301 for soldering to the PCB. The resilient connection component may be formed from a metal strip by a pick and place robot during the mounting process.

The meter casing base 101 is made by a polymer suitable for being ultrasonic or chemical welded to the meter casing cover 102. As an alternative to welding, the meter casing base and meter casing cover may be attached to each other by other means such as an irreversible click locking mechanism or glue. The meter casing cover is made from polymer and provided with an interfacing surface suitable for ultrasonic welding to the meter casing base. The meter casing cover has a display opening, an infrared communication port opening and light emission openings which all may be covered by a light transparent element (all not shown). Holes for buttons are provided to enable user interaction with the meter inside the meter casing. Further holes for various connectors are provided in the meter casing cover such as a RJ45 connector, input terminals, antenna connectors. Finally holes for operating the terminals are provided in the meter casing cover. When the connectors, buttons and transparent elements are mounted the internal of the meter casing is inaccessible through the openings in the meter casing cover. A terminal cover may be mounted on the meter casing to prevent unauthorized access and contact to the terminals or other parts of the meter. Such a terminal cover is normally mounted at the time of installing the electricity meter at a consumption site, where it may be sealed as well. During the production process the terminal cover may be mounted in a final step of production, but it must be removeable to enable installation of the meter. The meter casing is preferably made from a polymer but it may as well be made from a metal or a combination of both in that different elements of the meter casing may be made from different materials.

Another aspect of the invention is a production process for assembling the electricity meter as described in the first embodiment above. The production process comprising the following steps. A step of installing terminals 103 and bus bars 200 in the meter casing base 101. The bus bars 200 comprises a shunt resistor 201 and is arranged in the meter casing base 101 to connect two terminals 103. An optional step of installing an actuator device 220 for controlling the position of the breakers in the meter casing base. This optional step is relevant if the bus bar further comprises a breaker. A step of mounting components including resilient connection components 300 on the PCB 104 and soldering the components to the PCB 104 by at least one suitable soldering process, such as reflow soldering or wave soldering. Mounting of components on the PCB 104 may comprise a step of mounting surface mounted devices by a pick and place robot. A step of mounting the PCB 104 in the meter casing base 101 so that the shunt contact pins 202, 205 extends through holes 107 in the PCB and meets the resilient connection components 300. A step of welding the shunt contact pins 202, 205 to the resilient connection component 300 by a suitable welding process such as spot welding or laser welding. An optional step of mounting additional elements of the meter in the meter casing base 101. A step of mounting the meter casing cover 102 to the meter casing base 101. The total production process of the electricity meter may comprise additional steps, such as a step of calibration and a step of verification of the electricity meter. All of the steps may be automized and performed by industrial robots or other forms of industrial processes.

Although the present invention has been described in connection with the specified embodiments, it should not be construed as being in any way limited to the presented examples. The scope of the present invention is set out by the accompanying claim set. In the context of the claims, the terms "comprising" or "comprises" do not exclude other possible elements or steps. Also, the mentioning of references such as "a" or "an" etc. should not be construed as excluding a plurality. The use of reference signs in the claims with respect to elements indicated in the figures shall also not be construed as limiting the scope of the invention. Furthermore, individual features mentioned in different claims, may possibly be advantageously combined, and the mentioning of these features in different claims does not exclude that a combination of features is not possible and advantageous.

## Claims

1. An electricity meter (100) comprising:
- a controller unit for calculating an amount of consumed energy;
- at least two terminals (103) for connecting the electricity meter (100) to power lines;
- a measurement circuit connected to the controller unit and configured for generating a signal indicative of the amount of consumed energy, the measurement circuit comprising:
- a printed circuit board (104) with at least two resilient (300) connection components mounted on the circuit board (104);
- a shunt resistor (201) electrically connected to the terminals (103) and arranged for measuring a current running between two terminals (103), the shunt resistor (201) comprising at least two shunt contact pins (202, 205) for connecting the shunt resistor to the printed circuit board (104);
wherein the shunt contact pins (202, 205) are connected to the printed circuit board (104) via the pre-mounted resilient connection component (300) on the printed circuit board (104), by welding of the resilient connection component (300) to the shunt contact pins (202, 205), such that the shunt contact pin (202, 205) can move relative to the printed circuit board (104).

2. An electricity meter according to claim 1, wherein the shunt contact pins (202, 205) are made from copper.

3. An electricity meter according to any of the preceding claims, wherein the shunt contact pins (202, 205) extends through holes (107) in the printed circuit board (104) and wherein the holes (107) in the printed circuit board are larger than the shunt contact pins (202, 205) such that there is no direct contact between the shunt contact pins (202, 205) and the printed circuit board (104).

4. An electricity meter according to claim 3, wherein the resilient connection components (300) are mounted on a first side of the printed circuit board (104), and the shunt contact pins (202, 205) extends through the holes (107) in the printed circuit board (104) from a second side of the printed circuit board to the first side of the printed circuit board to be welded to the resilient connection components (300) mounted on the first side of the printed circuit board (104).

5. An electricity meter according to any of the preceding claims, wherein the resilient connection components (300) each are connected to the printed circuit board (104) via a surface mounted device foot print arranged on the printed circuit board and comprising at least two soldering pads.

6. An electricity meter according to claim 5, wherein the two pads of the surface mounted device foot print are positioned on opposite sides of the hole (107) in the printed circuit board (104).

7. An electricity meter according to any of the preceding claims, wherein the resilient connection components (300) are made from copper or aluminium.

8. An electricity meter according to any of the preceding claims, wherein the resilient connection components (300) are a metal strip with at least 4 or at least 6 bends.

9. An electricity meter according to any of the preceding claims, wherein the shunt resistor (201) is made from an alloy comprising copper, manganese and nickel.

10. An electricity meter according to any of the preceding claims, wherein the shunt resistor (201) is a part of a bus (200) bar which is arranged to connect two of the terminals (103).

11. An electricity meter according to claim 10, wherein the bus bar (200)comprises a breaker (204) for connecting and disconnecting two of the terminals.

12. An electricity meter according to claim 11, wherein the printed circuit board (104) further comprises inductive or capacitive position detection means for detecting a position of the breaker (204) and spring connectors for connecting terminals of a actuator of the breaker to the printed circuit board (104) whereby the printed circuit board may move relative to the breaker.

13. An electricity meter according to any of the preceding claims, wherein the resilient connection components (300) are surface mounted devices or through hole mounted devices.

## Patentansprüche

1. Elektrizitätszähler (100), umfassend:
- eine Steuereinheit zum Berechnen einer Menge an verbrauchter Energie;
- mindestens zwei Anschlüsse (103) zum Verbinden des Elektrizitätszählers (100) mit Stromleitungen;
- eine Messschaltung, die mit der Steuereinheit verbunden ist und zum Erzeugen eines Signals konfiguriert ist, das die Menge an verbrauchter Energie angibt, wobei die Messschaltung Folgendes umfasst:
- eine Leiterplatte (104) mit mindestens zwei auf der Leiterplatte (104) angebrachten elastischen (300) Verbindungskomponenten;
- einen Shunt-Widerstand (201), der mit den Anschlüssen (103) elektrisch verbundenen ist und zum Messen eines zwischen zwei Anschlüssen (103) fließenden Stroms angeordnet ist, wobei der Shunt-Widerstand (201) mindestens zwei Shunt-Kontaktstifte (202, 205) zum Verbinden des Shunt-Widerstands mit der Leiterplatte (104) umfasst;
wobei die Shunt-Kontaktstifte (202, 205) mit der Leiterplatte (104) über die zuvor angebrachte elastische Verbindungskomponente (300) auf der Leiterplatte (104) durch Verschweißen der elastischen Verbindungskomponente (300) mit den Shunt-Kontaktstiften (202, 205) verbunden sind, sodass sich der Shunt-Kontaktstift (202, 205) relativ zu der Leiterplatte (104) bewegen kann.

2. Elektrizitätszähler nach Anspruch 1, wobei die Shunt-Kontaktstifte (202, 205) aus Kupfer hergestellt sind.

3. Elektrizitätszähler nach einem der vorhergehenden Ansprüche, wobei sich die Shunt-Kontaktstifte (202, 205) durch Löcher (107) in der Leiterplatte (104) erstrecken und wobei die Löcher (107) in der Leiterplatte größer sind als die Shunt-Kontaktstifte (202, 205), sodass kein direkter Kontakt zwischen den Shunt-Kontaktstiften (202, 205) und der Leiterplatte (104) besteht.

4. Elektrizitätszähler nach Anspruch 3, wobei die elastischen Verbindungskomponenten (300) auf einer ersten Seite der Leiterplatte (104) angebracht sind und sich die Shunt-Kontaktstifte (202, 205) durch die Löcher (107) in der Leiterplatte (104) von einer zweiten Seite der Leiterplatte zu der ersten Seite der Leiterplatte erstrecken, um mit den elastischen Verbindungskomponenten (300), die auf der ersten Seite der Leiterplatte (104) angebracht sind, verschweißt zu werden.

5. Elektrizitätszähler nach einem der vorhergehenden Ansprüche, wobei die elastischen Verbindungskomponenten (300) jeweils über eine Grundfläche der auf der Oberfläche angebrachten Vorrichtung, die auf der Leiterplatte angeordnet ist und mindestens zwei Lötpads umfasst, mit der Leiterplatte (104) verbunden sind.

6. Elektrizitätszähler nach Anspruch 5, wobei die zwei Pads der Grundfläche der auf der Oberfläche angebrachten Vorrichtung auf gegenüberliegenden Seiten des Lochs (107) in der Leiterplatte (104) positioniert sind.

7. Elektrizitätszähler nach einem der vorhergehenden Ansprüche, wobei die elastischen Verbindungskomponenten (300) aus Kupfer oder Aluminium hergestellt sind.

8. Elektrizitätszähler nach einem der vorhergehenden Ansprüche, wobei die elastischen Verbindungskomponenten (300) ein Metallband mit mindestens 4 oder mindestens 6 Biegungen sind.

9. Elektrizitätszähler nach einem der vorhergehenden Ansprüche, wobei der Shunt-Widerstand (201) aus einer Legierung hergestellt ist, die Kupfer, Mangan und Nickel umfasst.

10. Elektrizitätszähler nach einem der vorhergehenden Ansprüche, wobei der Shunt-Widerstand (201) ein Teil einer Sammelschiene (200) ist, die dazu angeordnet ist, zwei der Anschlüsse (103) zu verbinden.

11. Elektrizitätszähler nach Anspruch 10, wobei die Sammelschiene (200) einen Unterbrecher (204) zum Verbinden und Trennen von zwei der Anschlüssen umfasst.

12. Elektrizitätszähler nach Anspruch 11, wobei die Leiterplatte (104) ferner eine induktive oder kapazitive Positionserfassungseinrichtung zum Erfassen einer Position des Unterbrechers (204) und Federverbinder zum Verbinden von Anschlüssen eines Betätigungselements des Unterbrechers mit der Leiterplatte (104) umfasst, wodurch sich die Leiterplatte relativ zu dem Unterbrecher bewegen kann.

13. Elektrizitätszähler nach einem der vorhergehenden Ansprüche, wobei die elastischen Verbindungskomponenten (300) auf der Oberfläche angebrachte Vorrichtungen oder durch ein Loch angebrachte Vorrichtungen sind.

## Revendications

1. Compteur d'électricité (100) comprenant :
- une unité de commande destinée à calculer une quantité d'énergie consommée ;
- au moins deux bornes (103) destinées à connecter le compteur d'électricité (100) aux lignes électriques ;
- un circuit de mesure connecté à l'unité de commande et configuré pour générer un signal indiquant la quantité d'énergie consommée, le circuit de mesure comprenant :
- une carte de circuit imprimé (104) avec au moins deux composants de connexion élastiques (300) montés sur la carte de circuit (104) ;
- une résistance de shunt (201) connectée électriquement aux bornes (103) et agencée pour mesurer un courant circulant entre deux bornes (103), la résistance de shunt (201) comprenant au moins deux broches de contact de shunt (202, 205) destinées à connecter la résistance de shunt à la carte de circuit imprimé (104) ;
lesdites broches de contact de shunt (202, 205) étant connectées à la carte de circuit imprimé (104) par l'intermédiaire du composant de connexion élastique prémonté (300) sur la carte de circuit imprimé (104), par soudage du composant de connexion élastique (300) aux broches de contact de shunt (202, 205), de sorte que la broche de contact de shunt (202, 205) puisse se déplacer par rapport à la carte de circuit imprimé (104).

2. Compteur d'électricité selon la revendication 1, lesdites broches de contact de shunt (202, 205) étant fabriqués en cuivre.

3. Compteur d'électricité selon l'une quelconque des revendications précédentes, lesdites broches de contact de shunt (202, 205) s'étendant à travers des trous (107) dans la carte de circuit imprimé (104) et lesdits trous (107) dans la carte de circuit imprimé étant plus grands que les broches de contact de shunt (202, 205) de sorte qu'aucun contact direct n'existe entre les broches de contact de shunt (202, 205) et la carte de circuit imprimé (104).

4. Compteur d'électricité selon la revendication 3, lesdits composants de connexion élastiques (300) étant montés sur un premier côté de la carte de circuit imprimé (104), et lesdites broches de contact de shunt (202, 205) s'étendant à travers les trous (107) dans la carte de circuit imprimé (104) à partir d'un second côté de la carte de circuit imprimé jusqu'au premier côté de la carte de circuit imprimé à souder aux composants de connexion élastiques (300) montés sur le premier côté de la carte de circuit imprimé (104).

5. Compteur d'électricité selon l'une quelconque des revendications précédentes, lesdits composants de connexion élastiques (300) étant chacun connectés à la carte de circuit imprimé (104) par l'intermédiaire d'une empreinte de dispositif montée en surface agencée sur la carte de circuit imprimé et comprenant au moins deux plots de soudure.

6. Compteur d'électricité selon la revendication 5, lesdits deux plots de l'empreinte de dispositif montée en surface étant positionnés sur des côtés opposés du trou (107) dans la carte de circuit imprimé (104).

7. Compteur d'électricité selon l'une quelconque des revendications précédentes, lesdits composants de connexion élastiques (300) étant fabriqués en cuivre ou en aluminium.

8. Compteur d'électricité selon l'une quelconque des revendications précédentes, lesdits composants de connexion élastiques (300) étant une bande métallique avec au moins 4 ou au moins 6 coudes.

9. Compteur d'électricité selon l'une quelconque des revendications précédentes, ladite résistance de shunt (201) étant fabriquée à partir d'un alliage comprenant du cuivre, du manganèse et du nickel.

10. Compteur d'électricité selon l'une quelconque des revendications précédentes, ladite résistance de shunt (201) faisant partie d'une barre omnibus (200) qui est agencée pour connecter deux des bornes (103).

11. Compteur d'électricité selon la revendication 10, ladite barre omnibus (200) comprenant un disjoncteur (204) pour connecter et déconnecter deux des bornes.

12. Compteur d'électricité selon la revendication 11, ladite carte de circuit imprimé (104) comprenant en outre un moyen de détection de position inductif ou capacitif destiné à détecter une position du disjoncteur (204) et des connecteurs à ressort destinés à connecter les bornes d'un actionneur du disjoncteur à la carte de circuit imprimé (104) moyennant quoi la carte de circuit imprimé peut se déplacer par rapport au disjoncteur.

13. Compteur d'électricité selon l'une quelconque des revendications précédentes, lesdits composants de connexion élastiques (300) étant des dispositifs montés en surface ou des dispositifs montés à travers un trou.
